# EUROPEAN PATENT SPECIFICATION

(11) **EP 3 335 829 B1**
(45) Date of publication and mention of the grant of the patent: **20.10.2021**
(21) Application number: 17820174.5
(22) Date of filing: 27.06.2017
(51) Int. Cl.: B23K 35/363, B23K 35/26, C22C 13/00, C22C 13/02, B23K 35/36, B23K 35/362, B23K 35/02, H05K 3/34

(54) **FLUX COMPOSITION, SOLDER PASTE COMPOSITION, AND ELECTRONIC CIRCUIT BOARD**
FLUSSMITTELZUSAMMENSETZUNG, LÖTPASTENZUSAMMENSETZUNG UND ELEKTRONISCHE LEITERPLATTE
COMPOSITION DE FLUX, COMPOSITION DE PÂTE À BRASER, ET CARTE À CIRCUIT ÉLECTRONIQUE

(30) Priority: 29.06.2016 JP 2016129417
(43) Date of publication of application: 20.06.2018
(73) Proprietor: Tamura Corporation, Tokyo 178-8511 (JP)
(72) Inventor: ARAI, Masaya, Iruma-shi Saitama 358-0032 (JP); KATSUYAMA, Tsukasa, Iruma-shi Saitama 358-0032 (JP); NAKANO, Takeshi, Iruma-shi Saitama 358-0032 (JP); HORI, Atsushi, Iruma-shi Saitama 358-0032 (JP); MUNEKAWA, Yurika, Iruma-shi Saitama 358-0032 (JP)
(74) Representative: Cabinet Beau de Loménie
(86) International application number: PCT/JP2017/023653
(87) International publication number: WO 2018/003820

(56) References cited:
- EP-A1- 2 692 479
- EP-A1- 2 939 784
- DE-A1- 2 246 827
- JP-A- H08 281 470
- JP-A- 2005 021 958
- JP-A- 2013 071 152
- JP-A- 2013 071 152
- JP-A- 2015 208 770
- JP-A- 2015 208 770
- US-A- 3 915 729

## Description

### Technical Field

The present invention relates to a flux composition, a solder paste composition, and an electronic circuit board comprising a solder joined body formed using the same.

In prior art, solder joining methods using solder paste compositions are used for joining electric components to electronic circuits formed on substrates such as printed circuit boards and silicon wafers. One of the solder joining methods is a printing method for printing a solder paste composition on a substrate.

This printing method generally uses a metal mask, into the opening of which a solder paste composition is charged with a squeegee for detaching the substrate from the metal mask, thereby transferring the solder paste composition to the substrate side. At this time, the solder paste composition adheres to the squeegee and the wall of the metal mask opening, which can cause a phenomenon in which the volume and shape transferred to the substrate do not accord with the design of the metal mask. In order to prevent this, solder paste compositions are required to have so-called printability which allows printing in accordance with the design of the metal mask. In particular, in recent years, as the electronic component terminals have more fine pitches, the openings of solder masks become finer. Therefore, the importance of printability applicable to these metal masks having fine openings is increasing.

In prior art, for the purpose of improving printability on fine pitch patterns, methods for refining the particle sizes of the solder powders comprised in solder paste compositions are proposed. However, in such solder powders, the surface areas of the particles are too great with respect to their volumes, which makes it very difficult to reduce the oxidation films on the surfaces of the solder powders, and to melt the solder powders. Therefore, such solder paste compositions have improved printability, but they can cause solder balls due to the decrease of wettability, and deterioration in storage stability.

As a method for resolving these problems, solder paste compositions comprising paraffin are proposed (Patent Literatures 1 to 3).

Patent Literature 1 discloses the addition of a predetermined amount of liquid paraffin to a flux for the purpose of improving the flowability of the flux, thereby allowing printing of fine pitches. Patent Literature 2 discloses the addition of a liquid paraffin or a paraffin wax as a moistureproof coating agent to a flux for the purpose of prevention of the strength deterioration caused by Zn ionization of a Sn-Zn lead free solder. Patent Literature 3 discloses the use of a predetermined amounts of a resin having a low glass transition temperature (Tg) and a paraffin wax having a melting point of 60°C or higher, for the purpose of preventing cracking in flux residues and improving adhesiveness of the flux residues after reflowing which tends to occur when using a resin having a low Tg, without impairing printability, wettability, and electrical reliability.

However, both of fine pitch electronic components and conventional large components may be mounted on the same substrate. When large components are mounted, the thickness of the metal mask is often set at a certain value or more (for example, from 150 µm to 160 µm) thereby keeping the solder supply to the electrode at a predetermined amount or more. In this case, the aspect ratio of the metal mask opening for the fine pitch electronic components increases, which easily causes adhesion of the solder paste composition to the walls of the metal mask opening, and tends to cause abnormalities in the transferred shape of the solder paste composition. Patent Literatures 1 to 3 do not refer to the problems caused during printing using a thick (for example, from 150 µm to 160 µm) metal mask corresponding to a design pattern in which both of fine pitch components and large components are mounted, and the printability resolving such problems.

Patent Literature 4 discloses a flux composition for soldering containing: (A) a solvent, (B) a rosin-based resin; and (C) an activator. The (A) component contains: (A1) a dicarboxylic acid having 4-8 carbon atoms and a dicarboxylic acid ester composed of alcohol having 1-7 carbon atoms; (A2) a glycol-based solvent whose boiling point at 760 mmHg is 220°C or more; and (A3) a hydrocarbon-based solvent whose boiling point at 760 mmHg is 145°C or less.

### Citation List:

Patent Literature 1: JP H07-132395 A Patent Literature 2: JP No. 4396162
Patent Literature 3: JP 2013-71152 A Patent Literature 4: JP 2015-208770 A.

### Summary of Invention

### Technical Problem

The present invention solves the above-described problems,and is intended to provide a flux composition and a solder paste composition which ensure good printability without impairing solderability (prevention of occurrence of voids and solder balls) and regardless of the metal mask thickness and opening diameter, and also provides reliability of the flux residue (adhesiveness and insulation resistance of the residue.

### Solution to Problem

The subject-matter of the present invention is defined by the claims.

### Advantageous Effects of Invention

According to the present invention, provided is a solder paste composition which ensures good printability without impairing solderability (prevention of occurrence of voids and solder balls) and regardless of the metal mask thickness and opening diameter, and also provides reliability of the flux residue (adhesiveness and insulation resistance of the residue) .

### Description of Embodiments

An Embodiment of the flux composition of the present disclosure, and solder paste composition, and electronic circuit board of the present invention is described below in detail. The present invention will not be, of course, limited to the embodiment.

### (1) Flux composition

The flux composition comprised in the solder paste composition of the present embodiment comprises a base resin (A), an activator (B), and a paraffin wax (C).

### (A) Base resin

The base resin (A) is preferably, for example, a rosin resin (A-1) and/or a synthetic resin (A-2).

Examples of the rosin resin (A-1) include rosin such as tall oil rosin, gum rosin, and wood rosin; rosin derivatives prepared by subjecting rosin to polymerization, hydrogenatation, disproportionation, acrylation, or maleation, esterification, or phenol addition reaction; and modified rosin resin obtained by subjecting any of these rosin or rosin derivatives and an unsaturated carboxylic acid (for example, acrylic acid, methacrylic acid, maleic acid anhydride, or fumaric acid) to Diels-Alder reaction. Among them, modified rosin resins are preferred, and hydrogenated acrylic acid-modified rosin resins obtained by hydrogenation of acrylic acid are particularly preferred. They may be used alone or in a combination of two or more of them.

The acid value of the rosin resin (A-1) is preferably from 140 mgKOH/g to 350 mgKOH/g, and the weight average molecular weight is preferably from 200 Mw to 1,000 Mw.

Examples of the synthetic resin (A-2) include derivative compounds obtained by dehydration condensation of acrylic resins, styrene-maleic acid resins, epoxy resins, urethane resins, polyester resins, phenoxy resins, terpene resins, polyalkylene carbonates, and carboxylic rosin resins with dimer acid-derived flexible alcohol compounds. They may be used alone or in a combination of two or more of them.

The acrylic resin is obtained by, for example, homopolymerization of (meth) acrylates having alkyl groups with 1 to 20 carbon atoms, or copolymerization of monomers of which the acrylates are the main components. Among these acrylic resins, preferred are acrylic resins obtained by polymerizing methacrylic acid with monomers comprising monomers having two saturated alkyl groups having 2 to 20 carbon atoms, the carbon chains being linear. These acrylic resins may be used alone or in a combination of two or more of them.

The epoxy resin may be any heat curing resins having reactive epoxy groups at their terminals, and examples thereof include bisphenol A type, bisphenol F type, bisphenol S type, biphenyl type, naphthalene type, cresol novolac type, phenol novolac type, brominated bisphenol A type, hydrogenated bisphenol A type, bisphenol AF type, fluorene type, glycidyl ether type, glycidyl ester type, glycidyl amine type, and alicyclic epoxy resins. They may be used alone or in a combination of two or more of them.

The urethane resin may be, for example, any one of those obtained by reacting a compound having plural isocyanate groups in one molecule with a polyol compound having two or more hydroxyl groups in one molecule, and among them, polyurethane resins comprising aliphatic components and aromatic components are particularly preferred. These urethane resins may be used alone or in a combination of two or more of them.

Examples of the polyester resin include polyethylene terephthalate, polytrimethylene terephthalate, polybutylene terephthalate, polyethylene naphthalate, and polybutylene naphthalate. They may be used alone or in a combination of two or more of them.

Examples of the phenoxy resin include bisphenol A type phenoxy resins and bisphenol F type phenoxy resins. They may be used alone or in a combination of two or more of them.

Examples of the polyalkylene carbonate include polyethylene carbonate, polypropylene carbonate, polybutene carbonate, polyisobutene carbonate, polypentene carbonate, polyhexene carbonate, polycyclopentene carbonate, polycyclohexene carbonate, polycycloheptene carbonate, polycyclooctene carbonate, polylimonene carbonate, polypropylene carbonate, and polybutylene carbonate. They may be used alone or in a combination of two or more of them.

Regarding the derivative compound (hereinafter referred to as "rosin derivative compound") obtained by dehydration condensation of the carboxylic rosin resin with the dimer acid-derived flexible alcohol compound, firstly, examples of the carboxylic rosin resin include rosin such as tall oil rosin, gum rosin, and wood rosin; and rosin derivatives such as hydrogenated rosin, polymerized rosin, disproportionated rosin, acrylic acid-modified rosin, and maleic acid-modified rosin, and other rosin having carboxyl groups may be used. They may be used alone or in a combination of two or more of them.

Secondly, examples of the dimer acid-derived flexible alcohol compound include the compounds which are derived from dimer acids such as dimer diol, polyester polyol, and polyester dimer diol, and have alcohol groups at their terminals, and may be, for example, PRIPOL2033, PRIPLAST3197, PRIPLAST1838 (Croda Japan KK).

The rosin derivative compound is obtained by dehydration condensation of the carboxylic rosin resin with the dimer acid-derived flexible alcohol compound. The method of the dehydration condensation may be an ordinarily used method. The ratio in the dehydration condensation of the carboxylic rosin resin and the dimer acid-derived flexible alcohol compound is preferably from 25:75 to 75:25.

The acid value of the synthetic resin (A-2) is preferably from 0 mgKOH/g to 150 mgKOH/g, and the weight average molecular weight is preferably from 1,000 Mw to 30,000 Mw.

The amount of the base resin (A) is 10% by mass or more and 60% by mass or less, and preferably 30% by mass or more and 55% by mass or less with reference to the total amount of the flux composition.

When the rosin resin (A-1) is used alone, its amount is preferably 10% by mass or more and 60% by mass or less, and more preferably 30% by mass or more and 55% by mass or less with reference to the total amount of the flux composition. When the amount of the rosin resin (A-1) is within this range, good solderability and adequate flux residue amount are achieved.

When the synthetic resin (A-2) is used alone, the amount is preferably 10% by mass or more and 60% by mass or less, and more preferably 30% by mass or more and 55% by mass or less with reference to the total amount of the flux composition.

Furthermore, when the rosin resin (A-1) and the synthetic resin (A-2) are used in a combination, the ratio is preferably from 20:80 to 50:50, and more preferably from 25:75 to 40:60.

### (B) Activator

Examples of the activator (B) include carboxylic acids and halogen-comprising compounds. They may be used alone or in a combination of two or more of them.

Examples of the carboxylic acid include monocarboxylic acids, dicarboxylic acids, and other organic acids.

Examples of the monocarboxylic acid include propionic acid, butyric acid, valeric acid, capronic acid, enanthic acid, capric acid, lauryl acid, myristic acid, pentadecyl acid, palmitic acid, margaric acid, stearic acid, tuberculostearic acid, arachidic acid, behenic acid, lignoceric acid, and glycolic acid.

Examples of the dicarboxylic acid include oxalic acid, malonic acid, succinic acid, glutaric acid, adipic acid, pimelic acid, suberic acid, azelaic acid, sebacic acid, fumaric acid, maleic acid, tartaric acid, and diglycolic acid.

Examples of the other organic acid include dimer acid, levulinic acid, lactic acid, acrylic acid, benzoic acid, salicylic acid, anisic acid, citric acid, and picolinic acid.

They may be used alone or in a combination of two or more of them.

Examples of the halogen-comprising compound include undissociative halogen compounds (undissociated activators) and dissociative halogen compounds (dissociated activators).

Examples of the undissociated activator include chlorine-free organic compounds whose halogen atoms are bonded by covalent bonds, and may be, for example, the compounds formed by covalent bonds between same elements such as chlorine, bromine, iodine, and fluorine, for example chloride, bromide, iodide, or fluoride, and the compounds formed by covalent bonds between two or more different halogen atoms. This compound preferably has a polar group such as a hydroxyl group, for example, halogenated alcohol, thereby improving solubility in aqueous solvents. Examples of the halogenated alcohol include brominated alcohols such as 2,3-dibromopropanol, 2,3-dibromobutanediol, 1,4-dibromo-2-butanol, and tribromoneopentylalcohol; chlorinated alcohols such as 1,3-dichloro-2-propanol, and 1,4-dichloro-2-butanol; fluorinated alcohols such as 3-fluorocatechol; and the other compounds of a similar kind.

Examples of the dissociated activator include hydrochloric acid salts and hydrobromides of bases such as amines and imidazoles. Examples of the salts of hydrochloric acid and hydrobromic acid include the hydrochloric acid salts and hydrobromides of amines having relatively small carbon numbers such as methylamine, dimethylamine, trimethylamine, ethylamine, diethylamine, triethylamine, n-propyl amine, di-n-propyl amine, tri-n-propyl amine, isopropylamine, diisopropylamine, butylamine, dibutylamine, tributylamine, cyclohexyl amine, monoethanolamine, diethanolamine, and triethanolamine; imidazole, 2-methylimidazole, 2-ethylimidazole, 2-methyl-4-methylimidazole, 2-methyl-4-ethylimidazole, 2-ethyl-4-ethylimidazole, 2-propyl imidazole, and 2-propyl-4-propyl imidazole. They may be used alone or in a combination of two or more of them.

The amount of the activator (B) is 0.1% by mass or more and 30% by mass or less, and preferably 2% by mass or more and 25% by mass or less with reference to the total amount of the flux composition.

The amount of the carboxylic acid comprised in the activator (B) is preferably 1% by mass or more and 25% by mass or less, and more preferably 5% by mass or more and 15% by mass or less with reference to the total amount of the flux composition . When the amount of the carboxylic acid is within this range, the occurrence of solder balls is prevented, and good insulation of the flux composition is achieved.

The amount of the undissociated activator comprised in the activator (B) is preferably 0.1% by mass or more and 5% by mass or less, and more preferably 0.5% by mass or more and 3% by mass or less with reference to the total amount of the flux composition.

The amount of the dissociated activator comprised in the activator (B) is preferably 0.1% by mass or more and 3% by mass or less, and more preferably 0.3% by mass or more and 1.5% by mass or less with reference to the total amount of the flux composition.

When the amine and the imidazole are respectively used alone as the dissociated activator, the amount is preferably 0.1% by mass or more and 5% by mass or less, and more preferably 0.5% by mass or more and 3% by mass or less.

### (C) Paraffin wax

The paraffin wax (C) is preferably one comprising, for example, isoparaffin or cycloparaffin. In particular, those comprising isoparaffin and/or cycloparaffin at a ratio of 9% by mass or more and 20% by mass or less are preferred.

The paraffin wax is generally classified into normal type (linear), iso type (branched), and cyclo type (cyclic) according to the shape of the paraffin (hydrocarbon) making up the paraffin wax, and the paraffin wax is a mixture of them. The paraffin wax (C) according to this embodiment comprises isoparaffin and/or cycloparaffin having a fine crystal structure at a ratio of 9% by mass or more and 20% by mass or less, thereby giving flexibility to the flux composition, improving its printability, and maintaining good adhesiveness of the flux residue. The content of the isoparaffin and/or cycloparaffin is more preferably 9% by mass or more and 13% by mass or less. When the content is within this range, printability and adhesiveness of the flux residue can be further improved.

If the content of the isoparaffin and/or cycloparaffin in the paraffin wax (C) is more than 20% by mass, a good print shape of the flux composition and adhesiveness of the flux residue may not be ensured, and if the content is less than 9% by mass, voids easily occur in the solder joints formed with the solder paste composition comprising the flux composition, and the flux residue remaining around the solder joints tends to harden, and cracks tend to appear in the residue due to heat shocks, which can result in impairment of electrical reliability.

The paraffin waxes (C) may be used alone or in a combination of two or more of them.

The carbon number distribution of the paraffin wax (C) is preferably from 16 to 50. The range is more preferably from 18 to 49, and particularly preferably from 18 to 38.

The weight average molecular weight of the paraffin wax (C) is preferably 300 Mw or more and 600 Mw or less. The range is more preferably from 300 Mw to 510 Mw, even more preferably from 300 Mw to 390 Mw, and particularly preferably from 340 Mw to 390 Mw. When the weight average molecular weight is within this range, printability of the solder paste composition is further improved.

Furthermore, the paraffin wax (C) preferably consists of carbon and hydrogen.

Particularly preferred examples of the paraffin wax (C) include the following.
- Those comprising isoparaffin and/or cycloparaffin at a ratio of 9.5% by mass, having a carbon number distribution range of 19 to 38, and a weight average molecular weight of 390 Mw
- Those comprising isoparaffin and/or cycloparaffin at a ratio of 19.4% by mass, having a carbon number distribution range of 18 to 36, and a weight average molecular weight of 340 Mw
- Those comprising isoparaffin and/or cycloparaffin at a ratio of 14.3% by mass, having a carbon number distribution range of 28 to 49, and a weight average molecular weight of 510 Mw

The content of the isoparaffin and/or cycloparaffin, carbon number distribution, and weight average molecular weight of the paraffin wax (C) are measured by qualitative and quantitative analyses in accordance with the specification number JIS K 0114:2012 "Gas Chromatography General Rule".

Furthermore, the amount of the paraffin wax (C) is from 0.5% by mass to 20% by mass with reference to the total amount of the flux composition, and more preferably from 0.5% by mass to 2% by mass. When the amount of the paraffin wax (C) is from 0.5% by mass to 2% by mass, printability and adhesiveness of the residue are improved without impairing solderability (voids and solder balls).

Paraffin waxes other than the paraffin wax (C) may be combined within a range as long as they do not affect the effect of the flux composition.

The flux composition of the present embodiment may further comprise a solvent. Examples of the solvent include isopropyl alcohol, ethanol, acetone, toluene, xylene, ethyl acetate, ethyl cellosolve, butyl cellosolve, hexyl diglycol, (2-ethylhexyl) diglycol, phenyl glycol, butyl carbitol, octanediol, α-terpineol, β-terpineol, tetraethylene glycol dimethyl ether, tris (2-ethylhexyl)trimellitate, and bisisopropyl sebacate. They may be used alone in a combination of two or more of them.

The amount of the solvent is preferably 20% by mass or more and 65% by mass or less, more preferably 20% by mass or more and 60% by mass or less, and even more preferably 25% by mass or more and 50% by mass or less with reference to the total amount of the flux composition.

Additionally, the flux composition comprised in the solder composition of the present embodiment may comprise a thixotropic agent, a drip preventive agent, and a gelling agent as thickening agents for the purpose of adjusting the viscosity of the flux composition.

Examples of the thickening agent include hydrogenated castor oil, saturated fatty acid amide, saturated fatty acid bisamides, oxyfatty acids, and dibenzylidene sorbitols. They may be used alone or in in a combination of two or more of them.

The amount of the thickening agent is preferably 1% by mass or more and 15% by mass or less, and more preferably 3% by mass or more and 10% by mass or less with reference to the total amount of the flux composition.

Additionally, the flux composition comprised in the solder composition of the present embodiment may comprise additives if necessary. Examples of the additive include an antioxidant, an anti-foaming agent, a surfactant, and a delustering agent. They may be used alone in a combination of two or more of them.

The amount of the additive is preferably 0.5% by mass or more and 20% by mass or less, and more preferably 1% by mass or more and 15% by mass or less with reference to the total amount of the flux composition.

### (2) Solder paste composition

The solder paste composition of the present embodiment can be obtained by mixing the flux composition and the solder alloy powder.

The solder alloy powder may be lead-comprising/lead-free solder alloy powder. More specifically, the solder paste composition of the present embodiment ensures good printability regardless of the components of the solder alloy powder comprised therein, without impairing solderability (prevention of occurrence of voids and solder balls), and regardless of the metal mask thickness and opening diameter, and also provides reliability of the flux residue (adhesiveness and insulation resistance of the residue).

Examples of the alloy which can be used in the solder alloy powder of the present disclosure include alloys comprising Sn and Pb, alloys comprising
Sn, Pb, and at least one of Ag, Bi, and In, alloys comprising Sn and Ag, alloys comprising Sn and Cu, alloys comprising Sn, Ag, and Cu, and alloys comprising Sn and Bi. Other examples include solder alloy powders comprising appropriate combinations of, for example, Sn, Pb, Ag, Bi, In, Cu, Zn, Ga, Sb, Au, Pd, Ge, Ni, Cr, Al, P, Co, and Fe. The elements other than above-listed ones may be used in these combinations.

In the present invention, the solder alloy powders are solder alloy powders comprising Sn, Ag, and Cu, such as the powders of Sn-Ag alloy solders, Sn-Ag-Cu solder alloys, and Sn-Ag-Cu-Bi solder alloys.

Among them, when the solder alloy powder having the alloy constitution described below is used, the crack growth inhibitory effect on the solder joint to be formed can be improved.

More specifically, the solder alloy powder preferably comprises 1% by mass or more and 3.1% by mass or less of Ag, more than 0% by mass and 1% by mass or less of Cu, 1% by mass or more and 5% by mass or less of Sb, 0.5% by mass or more and 4.5% by mass or less of Bi, 0.01% by mass or more and 0.25% by mass or less of Ni, the balance being Sn.

The Ag content is more preferably 2% by mass or more and 3.1% by mass or less, the Cu content is more preferably 0.5% by mass or more and 1% by mass or less, the Sb content is more preferably 2% by mass or more and 4% by mass or less, the Bi content is more preferably 3.1% by mass or more and 4.5% by mass, and the Ni content is more preferably 0.01% by mass or more and 0.15% by mass or less.

The solder alloy powder preferably further comprises 0.001% by mass or more and 0.25% by mass or less of Co. The Co content is more preferably 0.001% by mass or more and 0.15% by mass or less.

When this solder alloy powder is used, the solder joint formed using the solder paste composition according to the present embodiment prevents the growth of cracks in the solder joint even in a severe environment exposed to extreme temperature differences and vibrations. Furthermore, even when a solder joint is formed using an electronic component without Ni/Pd/Au plating or Ni/Au plating, crack growth in the vicinity of the interface between the solder joint and the lower surface electrode of the electronic component can be prevented.

The amount of the solder alloy powder is preferably from 65% by mass to 95% by mass with reference to the total amount of the solder paste composition. The amount is more preferably from 85% by mass to 93% by mass, and particularly preferably from 87% by mass to 92% by mass.

When the amount of the solder alloy powder is less than 65% by mass, the solder paste composition obtained tends to fail to form a satisfactory solder joint. On the other hand, if the content of the solder alloy powder is more than 95% by mass, the flux composition as a binder is insufficient, so that mixing of the flux composition and the solder alloy powder tends to be difficult.

The particle size of the solder alloy powder is preferably 1 µm or more and 40 µm or less, more preferably 5 µm or more and 35 µm or less, and particularly preferably 10 µm or more and 30 µm or less.

When the solder paste composition of the present embodiment comprises the above-described flux composition, it ensures good printability without impairing solderability (prevention of occurrence of voids and solder balls) and regardless of the metal mask thickness and opening diameter, and also provides reliability of the flux residue (adhesiveness and insulation resistance of the residue).

### (3) Electronic circuit board

The electronic circuit board of the present embodiment preferably comprises a solder joint and a flux residue formed using the solder paste composition (in the present description, the solder joint and the flux residue are referred to as "solder joined body" altogether) . The electronic circuit board is made by, for example, forming an electrode and a solder resist film at a predetermined position on a substrate, printing the solder paste composition of the present embodiment using a mask having a predetermined pattern, mounting the electronic component corresponding to the pattern at a predetermined position, and reflowing the object.

On the electronic circuit board thus made, a solder joint is formed on the electrode, and the solder joint electrically joins the electrode and the electronic component. In addition, a flux residue is deposited on the substrate so as to adhere at least to the solder joint.

In the electronic circuit board of the present embodiment, the solder joint is formed using the solder paste composition, which allows pattern formation as designed irrespective of the metal mask thickness and the opening diameter, and to prevent the occurrence of voids and solder balls in the solder joint. In addition, since the flux residue is formed from the flux composition, it has good adhesiveness and insulation resistance. In addition, the alloy composition of the solder alloy powder comprises specific elements at specific contents, which can improve the crack growth inhibitory effect of the solder joint.

### Examples

The present invention is described below in detail with reference to Examples and Comparative Examples. The present invention will not be limited to these examples.

### <Preparation of synthetic resin>

200 g of diethylene glycol monohexyl ether was charged into a 500-mL four-necked flask equipped with a stirrer, a reflux tube, and a nitrogen introduction tube, and heated to 110°C.

Additionally, 0.2% by mass to 5% by mass of dimethyl 2,2'-azobis(2-methyl propionate) (product name: V-601, Wako Pure chemical Industries, Ltd.) as an azo type radical initiator was added to and dissolved in 300 g of a mixture comprising 10% by mass of methacrylic acid, 51% by mass of 2-ethylhexyl methacrylate, and 39% by mass of lauryl acrylate, thus preparing a solution.

Subsequently, the solution was dropped into the four-necked flask over a period of 1.5 hours, and stirred at 110°C for 1 hour, and a synthetic resin (A-2) used in Examples was thus obtained. The synthetic resin (A-2) had a weight average molecular weight of 7,800 Mw, an acid value of 40 mgKOH/g, and a glass transition temperature of -47°C.

### <Preparation of flux composition>

The components listed in Table 1 were blended, thus obtaining the flux compositions comprised in the scope of the solder paste composition of the present invention (Preparation Examples a to h) and the flux compositions not comprised in the scope of the solder paste composition of the present invention (Preparation Examples i to n).

The values listed in Table 1 represent % by mass unless otherwise specified. The synthetic resin (A-2) was the resin in a solvent state prepared in the above-described procedure from which the solvent was evaporated using an evaporator. Therefore, the values of the synthetic resin (A-2) listed in Table 1 refer to the solid content alone after evaporating the solvent.

### <Preparation of solder paste composition>

Subsequently, according to the matrix table in Table 2, 11% by mass of the flux composition and 89% by mass of the solder alloy powders comprising the alloys A to E were mixed, thus obtaining the solder paste compositions according to Examples 1 to 40 and the solder paste compositions according to Comparative Examples 1 to 30.
- Examples 1 to 8 and Comparative Examples 1 to 6: the solder alloy powder comprising the alloy A and the flux compositions according to Preparation Examples a to n were blended
- Examples 9 to 16 and Comparative Examples 7 to 12: the solder alloy powder comprising the alloy B and the flux compositions according to Preparation Examples a to n were blended
- Examples 17 to 24 and Comparative Examples 13 to 18: the solder alloy powder comprising the alloy C and the flux compositions according to Preparation Examples a to n were blended
- Examples 25 to 32 and Comparative Examples 19 to 24: the solder alloy powder comprising the alloy D and the flux compositions according to Preparation Examples a to n were blended
- Examples 33 to 40 and Comparative Examples 25 to 30: the solder alloy powder comprising the alloy E and the flux compositions according to Preparation Examples a to n were blended
   Alloy A: Sn-3Ag-0.5Cu
   Alloy B: Sn-3Ag-0.7Cu-3.5Bi-3Sb-0.04Ni-0.01Co
   Alloy C: Sn-3Ag-0.5Cu-4.5Bi-3Sb-0.03Ni
   Alloy D: Sn-3Ag-0.5Cu-3Bi-2Sb-0.03Ni
   Alloy E: Sn-3Ag-0.7Cu-3.2Bi-3Sb-0.03Ni-0.01Co-0.05Fe

**[Table 1]**

| | | Preparation Example a | Preparation Example b | Preparation Example c | Preparation Example d | Preparation Example e | Preparation Example f | Preparation Example g | Preparation Example h | Preparation Example i | Preparation Example j | Preparation Example k | Preparation Example l | Preparation Example m | Preparation Example n |
|---|---|---|---|---|---|---|---|---|---|---|---|---|---|---|---|
| (A-1) Rosin resin | KE-604 *1 | 50 | | 15 | 15 | 15 | 12 | 15 | 15 | 50 | | 15 | 10.5 | 15 | 15 |
| (A-2) Synthetic resin | | | 50 | 35 | 35 | 35 | 28 | 35 | 35 | | 50 | 35 | 24.5 | 35 | 35 |
| (B) Activator | Malonic acid | 0.5 | 0.5 | 0.5 | 0.5 | 0.5 | 0.5 | 0.5 | 0.5 | 0.5 | 0.5 | 0.5 | 0.5 | 0.5 | 0.5 |
| | Succinic acid | 0.5 | 0.5 | 0.5 | 0.5 | 0.5 | 0.5 | 0.5 | 0.5 | 0.5 | 0.5 | 0.5 | 0.5 | 0.5 | 0.5 |
| | Suberic acid | 3.0 | 3.0 | 3.0 | 3.0 | 3.0 | 3.0 | 3.0 | 3.0 | 3.0 | 3.0 | 3.0 | 3.0 | 3.0 | 3.0 |
| | Picolinic acid | 1.0 | 1.0 | 1.0 | 1.0 | 1.0 | 1.0 | 1.0 | 1.0 | 1.0 | 1.0 | 1.0 | 1.0 | 1.0 | 1.0 |
| | 2-bromohexanoic acid | 1.5 | 1.5 | 1.5 | 1.5 | 1.5 | 1.5 | 1.5 | 1.5 | 1.5 | 1.5 | 1.5 | 1.5 | 1.5 | 1.5 |
| (C) Paraffin wax | Paraffin wax C-1 | | | | | | | 9 | | | | | | | |
| | Paraffin wax C-2 | 9 | 9 | 0.5 | 2 | 9 | 20 | | | | | | 25 | | |
| | Paraffin wax C-3 | | | | | | | | 9 | | | | | | |
| | Paraffin wax C-4 | | | | | | | | | | | | | | 9 |
| | Paraffin wax C-5 | | | | | | | | | | | | | 9 | |
| Solvent | Diethylene glycol monohexyl ether | 28.5 | 28.5 | 37 | 35.5 | 28.5 | 27.5 | 28.5 | 28.5 | 37.5 | 37.5 | 37.5 | 27.5 | 28.5 | 28.5 |
| Thixotropic agent | SLIPAX ZHH *2 | 5 | 5 | 5 | 5 | 5 | 5 | 5 | 5 | 5 | 5 | 5 | 5 | 5 | 5 |
| Antioxidant | IRGANOX 245 *3 | 1 | 1 | 1 | 1 | 1 | 1 | 1 | 1 | 1 | 1 | 1 | 1 | 1 | 1 |

| | | | | | | | | | | | | | | | |
|---|---|---|---|---|---|---|---|---|---|---|---|---|---|---|---|
| *1 Hydrogenated acid-modified rosin, Arakawa Chemical Industries, Ltd. *2 Fatty acid bisamide, Nippon Kasei Chemical Co., Ltd. *3 Hindered phenol antioxidant, BASF Japan | | | | | | | | | | | | | | | |

**[Table 2]**

| | Alloy A | Alloy B | Alloy C | Alloy D | Alloy E |
|---|---|---|---|---|---|
| Preparation Example a | Example 1 | Example 9 | Example 17 | Example 25 | Example 33 |
| Preparation Example b | Example 2 | Example 10 | Example 18 | Example 26 | Example 34 |
| Preparation Example c | Example 3 | Example 11 | Example 19 | Example 27 | Example 35 |
| Preparation Example d | Example 4 | Example 12 | Example 20 | Example 28 | Example 36 |
| Preparation Example e | Example 5 | Example 13 | Example 21 | Example 29 | Example 37 |
| Preparation Example f | Example 6 | Example 14 | Example 22 | Example 30 | Example 38 |
| Preparation Example q | Example 7 | Example 15 | Example 23 | Example 31 | Example 39 |
| Preparation Example h | Example 8 | Example 16 | Example 24 | Example 32 | Example 40 |
| Preparation Example i | Comparative Example 1 | Comparative Example 7 | Comparative Example 13 | Comparative Example 19 | Comparative Example 25 |
| Preparation Example j | Comparative Example 2 | Comparative Example 8 | Comparative Example 14 | Comparative Example 20 | Comparative Example 26 |
| Preparation Example k | Comparative Example 3 | Comparative Example 9 | Comparative Example 15 | Comparative Example 21 | Comparative Example 27 |
| Preparation Example l | Comparative Example 4 | Comparative Example 10 | Comparative Example 16 | Comparative Example 22 | Comparative Example 28 |
| Preparation Example m | Comparative Example 5 | Comparative Example 11 | Comparative Example 17 | Comparative Example 23 | Comparative Example 29 |
| Preparation Example n | Comparative Example 6 | Comparative Example 12 | Comparative Example 18 | Comparative Example 24 | Comparative Example 30 |

Table 3 lists the normal paraffin content rate, carbon number distribution range, and weight average molecular weight of the paraffin waxes C-1 to C-5 listed in Table 1.

**[Table 3]**

| | Normal paraffin content rate | Isoparaffin and/or cycloparaffin content rate | Carbon number distribution range | Weight average molecular weight |
|---|---|---|---|---|
| C-1 | 80.6% by mass | 19.4% by mass | 18-36 | 340 Mw |
| C-2 | 90.5% by mass | 9.5% by mass | 19 - 38 | 390 Mw |
| C-3 | 85.7% by mass | 14.3% by mass | 28-49 | 510 Mw |
| C-4 | 31.4% by mass | 68.6% by mass | 16 - 39 | 370 Mw |
| C-5 | 70.3% by mass | 29.7% by mass | 23 - 48 | 490 Mw |

### <Printability test (1)>

A glass epoxy substrate and a QFP (PKG size: 28 mm × 28 mm × 3.2 mm) with 208 pin, 0.5 mm pitch were provided. On the glass epoxy substrate, a solder resist and an electrode (1.3 mm × 0.25 mm) corresponding to the QFP were provided, and then the solder paste compositions according to Examples 1 to 40 and Comparative Examples 1 to 30 were respectively printed on the glass epoxy substrate using a 160-µm-thick metal mask having the corresponding pattern, in which each solder paste composition was successively printed on six substrates, thus making the test substrates. The print pattern on these substrates was evaluated according to the following criteria using an image tester (product name: Aspire2, Koh Young Technology Inc.). The results are given in Tables 4 to 8.
⊙ : The number of generated spikes having a difference in height (the value obtained by subtracting the average height of the print shape from the apex height; hereinafter the same) of 150 µm or more is 0
○ : The number of generated spikes having a difference in height of 150 µm or more is one or more and 10 or less
Δ : The number of generated spikes having a difference in height of 150 µm or more is 11 or more and 20 or less
× : The number of generated spikes having a difference in height of 150 µm or more is 21 or more

### <Printability test (2)>

Test substrates were made under the same conditions as in the printability test (1), and the print pattern on these substrates was evaluated according to the following criteria using an image tester (product name: Aspire2, Koh Young Technology Inc.). The results are given in Tables 4 to 8.
⊙ : The maximum value of the difference in height is 200 µm or less
○: The maximum value of the difference in height is more than 200 µm and 250 µm or less
Δ : The maximum value of the difference in height is more than 250 µm and 350 µm or less
× : The maximum value of the difference in height is more than 350 µm

### <Flux residue adhesiveness test>

Glass epoxy substrates were provided, and a solder resist having a pattern with a diameter of 6 mm, and a copper land were formed on the substrates. Using a 150-µm-thick metal mask having the same pattern, the solder paste compositions according to Examples 1 to 40 and Comparative Examples 1 to 30 were respectively printed on the glass epoxy substrate. Subsequently, these glass epoxy substrates were heated using a reflow furnace (product name: TNP-538EM, Tamura Corporation), thus making the test substrates. The reflow conditions were as follows: preheating was 90 seconds at 170°C to 180°C, peak temperature was 230°C, the time at 220°C or higher was 30 seconds or less, and the cooling rate from the peak temperature to 200°C was from 3°C to 8°C/second. The oxygen concentration in the reflow furnace was adjusted at 1500 ± 500 ppm.

These test substrates were allowed to stand at room temperature for 2 hours, solder balls having a diameter of 300 µm were sprinkled over the flux residue formed on the test substrates which had been soldered according to the 6-mm-diameter pattern, and these objects were hurled and impacted against a desk in such a manner that the sides of the test substrates were in parallel with the ground. Thereafter, the number of solder balls adhered to the flux residue on the test substrates was counted, and evaluated according to the following criteria. The results are given in Tables 4 to 8.
⊙ : The number of adhered solder balls is 0
○ : The number of adhered solder balls is one or more and 10 or less
Δ : The number of adhered solder balls is 11 or more and 30 or less
× : The number of adhered solder balls is 31 or more

### <Copper plate corrosion test>

The solder paste compositions according to Examples 1 to 40 and Comparative Examples 1 to 30 were subjected to the test according to the conditions defined in Specification No. IEC 61189-5/8.1, and evaluated as follows. The results are given in given in Tables 4 to 8.
○ : No corrosion
× : Corroded

### <Insulation resistance test>

Using the solder paste compositions according to Examples 1 to 40 and Comparative Examples 1 to 30, test pieces were made according to the conditions defined in Specification No. IEC 61189-5/10.1. For these test pieces, a comb teeth-like substrate (size: 50 mm × 50 mm) having a conductor width and a conductor interval of 0.318 mm, respectively, was used, and the insulation resistance between the electrodes of the test pieces was measured at 85°C, 85% R.H. (relative humidity), and under a direct voltage of 32 V. The results are given in Tables 4 to 8.
○ : The initial measurement value is 1.0 × 10⁹ Ω or more
× : The initial measurement value is less than 1.0 × 10⁹ Ω

### <Solder ball test>

Glass epoxy substrates and chip components of 2.0 mm × 1.2 mm were provided. On the glass epoxy substrates, a solder resist and an electrode (1.25 mm × 1.0 mm) corresponding to the above-described chip components were formed, and the solder paste compositions according to Examples 1 to 40 and Comparative Examples 1 to 30 were respectively printed on the glass epoxy substrates using a 150-µm-thick metal mask having the corresponding pattern as the solder resist and electrode, thus mounting the chip components. Subsequently, these glass epoxy substrates were heated using a reflow furnace (product name: TNP-538EM, Tamura Corporation), thus making the test substrates. The reflow conditions were as follows: preheating was 110 seconds at 170°C to 190°C, peak temperature was 260°C, the time at 200°C or higher was 70 seconds, the time at 220°C or higher was 60 seconds, and the cooling rate from the peak temperature to 200°C was from 3°C to 8°C/second. The oxygen concentration in the reflow furnace was adjusted at 1500 ± 500 ppm.

These test substrates were observed with X ray transmission equipment (product name: SMX-160E, Shimadzu Corporation), and the number and diameter of solder balls generated around and under the chip components were counted, and evaluated as follows. The results are given in Tables 4 to 8.
⊙ : The number of balls which occurred per ten chip resistance of 2.0 mm × 1.2 mm is 0
○ : The number of balls which occurred per ten chip resistance of 2.0 mm × 1.2 mm is 1 or more and 10 or less, and the maximum diameter of the occurred ball is 200 µm or less
Δ : The number of balls which occurred per ten chip resistance of 2.0 mm × 1.2 mm is 1 or more and 10 or less, and the maximum diameter of the occurred ball is more than 200 µm
× : The number of balls which occurred per ten chip resistance of 2.0 mm × 1.2 mm is 11 or more

### <Void test>

The test substrates were made under the same conditions as in the solder ball test, the surface state was observed with X-ray transmission equipment (product name: SMX-160E, Shimadzu Corporation), and the ratio of the total area of voids in the region on which a solder joint is formed (void area ratio) was measured. The maximum value of the void area ratio in 20 lands in each test substrate was calculated, and the occurrence of voids was evaluated as follows. The results are given in Tables 4 to 8.
⊙ : The maximum value of the void area ratio is 10% or less
○ : The maximum value of the void area ratio is more than 10% and 13% or less
Δ : The maximum value of the void area ratio is more than 13% and 20% or less
× : The maximum value of the void area ratio is more than 20%

### <Solder cracking test>

A glass epoxy substrate comprising a 3.2 mm × 1.6 mm chip component (Ni/Sn-plated), a solder resist having a pattern on which the chip component of the above-described size can be mounted, and an electrode (1.6 mm × 1.2 mm) for connecting the chip component, and a 150-µm-thick metal mask having the corresponding pattern were provided.

The solder paste compositions according to Examples 1 to 40 and Comparative Examples 1 to 30 were respectively printed on the glass epoxy substrates using the metal masks, and the chip components were mounted thereon.

Thereafter, the glass epoxy substrates were heated with a reflow furnace (product name: TNP-538EM, Tamura Corporation), solder joints which electrically join the glass epoxy substrates and the chip components were respectively formed on them, and the chip component were mounted on them. The reflow conditions at this time were as follows: preheating was 110 seconds from 170°C to 190°C, the peak temperature was 245°C, the time at 200°C or higher was 65 seconds, the time at 220°C or higher was 45 seconds, the cooling rate from the peak temperature to 200°C was from 3°C to 8°C/second, and the oxygen concentration was adjusted at 1500 ± 500 ppm.

Subsequently, using a thermal shock testing machine set at -40°C (30 minutes) to 125°C (30 minutes) (product name: ES-76LMS, Hitachi Appliance, Inc.), the glass epoxy substrates were exposed to an environments in which the thermal shock cycle was repeated 1,000, 1,500, 2,000, 2,500, and 3,000 cycles, and then the substrates were taken out, thus making the test substrates.

Subsequently, the object portions of the test substrates were cut out, and sealed using an epoxy resin (product name: EPOMOUNT (main agent and curing agent), Refine Tec Ltd.). Furthermore, using a wet polisher (product name: TegraPol-25, Marumoto Struers K.K.), the central cross section of the chip components mounted on the test substrates were made visible, and whether the cracks generated in the formed solder joints were completely crossing the solder joints to cause a rupture or not was observed using a scanning electronic microscope (product name: TM-1000, Hitachi High-Technologies Corporation), and evaluated according to the following criteria. The results are given in Tables 4 to 8. The number of the chips tested by the thermal shock cycles was ten.
⊙⊙ : Cracks completely crossing the solder joint did not occur up to 3,000 cycles
⊙ : Cracks completely crossing the solder joint occurred between 2,501 and 3,000 cycles
○ : Cracks completely crossing the solder joint occurred between 2,001 and 2,500 cycles
Δ : Cracks completely crossing the solder joint occurred at 2,000 cycles or less

**[Table 4]**

| | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|---|---|
| Printability test (1) | ⊙ | ⊙ | ○ | ○ | ⊙ | Δ | Δ | ○ | × | × | × | Δ | × | Δ |
| Printability test (2) | ⊙ | ⊙ | ⊙ | ⊙ | ⊙ | Δ | ○ | Δ | Δ | Δ | Δ | Δ | ○ | Δ |
| Flux residue adhesiveness test | ⊙ | Δ | ○ | ○ | ⊙ | ⊙ | ○ | ○ | ⊙ | × | Δ | ⊙ | Δ | Δ |
| Copper plate corrosion test | O | ○ | ○ | ○ | ○ | ○ | ○ | ○ | ○ | ○ | ○ | ○ | ○ | ○ |
| Insulation resistance test | ○ | ○ | ○ | ○ | ○ | ○ | ○ | ○ | ○ | ○ | ○ | ○ | ○ | ○ |
| Solder ball test | ⊙ | Δ | ○ | ○ | Δ | Δ | Δ | Δ | O | ○ | ○ | × | Δ | Δ |
| Void test | ⊙ | Δ | ○ | ○ | Δ | Δ | ○ | Δ | ⊙ | Δ | ○ | × | × | Δ |
| Solder crack test | Δ | Δ | Δ | Δ | Δ | Δ | Δ | Δ | Δ | Δ | Δ | Δ | Δ | Δ |

**[Table 5]**

| | Example 9 | Example 10 | Example 11 | Example 12 | Example 13 | Example 14 | Example 15 | Example 16 | Comparative Example 7 | Comparative Example 8 | Comparative Example 9 | Comparative Example 10 | Comparative Example 11 | Comparative Example 12 |
|---|---|---|---|---|---|---|---|---|---|---|---|---|---|---|
| Printability test (1) | ⊙ | ⊙ | ○ | ○ | ⊙ | Δ | Δ | ○ | × | × | × | Δ | × | Δ |
| Printability test (2) | ⊙ | ⊙ | ⊙ | ⊙ | ⊙ | Δ | ○ | Δ | Δ | Δ | Δ | Δ | ○ | Δ |
| Flux residue adhesiveness test | ⊙ | Δ | ○ | ○ | ⊙ | ⊙ | ○ | ○ | ⊙ | × | Δ | ⊙ | Δ | Δ |
| Copper plate corrosion test | ○ | ○ | ○ | ○ | ○ | ○ | ○ | ○ | ○ | ○ | ○ | ○ | ○ | ○ |
| Insulation Iresistance test | ○ | ○ | ○ | ○ | ○ | ○ | ○ | ○ | ○ | ○ | ○ | ○ | ○ | ○ |
| Solder ball test | ⊙ | Δ | ○ | ○ | Δ | Δ | Δ | Δ | ⊙ | ○ | ○ | × | Δ | Δ |
| Void test | ⊙ | Δ | ○ | ○ | Δ | Δ | ○ | Δ | ⊙ | Δ | ○ | × | × | Δ |
| Solder crack test | ⊙ | ○ | ○ | ○ | ○ | ○ | ○ | ○ | ⊙ | ○ | ○ | ○ | ○ | ○ |

**[Table 6]**

| | Example 17 | Example 18 | Example 19 | Example 20 | Example 21 | Example 22 | Example 23 | Example 24 | Comparative Example 13 | Comparative Example 14 | Comparative Example 15 | Comparative Example 16 | Comparative Example 17 | Comparative Example 18 |
|---|---|---|---|---|---|---|---|---|---|---|---|---|---|---|
| Printability test (1) | ⊙ | ⊙ | ○ | ○ | ⊙ | Δ | Δ | ○ | × | × | × | Δ | × | Δ |
| Printability test (2) | ⊙ | ⊙ | ⊙ | ⊙ | ⊙ | Δ | ○ | Δ | Δ | Δ | Δ | Δ | ○ | Δ |
| Flux residue adhesiveness test | ⊙ | Δ | ○ | ○ | ⊙ | ⊙ | ○ | ○ | ⊙ | × | Δ | ⊙ | Δ | Δ |
| Copper plate corrosion test | ○ | ○ | ○ | ○ | ○ | ○ | ○ | ○ | ○ | ○ | ○ | ○ | ○ | ○ |
| Insulation resistance test | ○ | ○ | ○ | ○ | ○ | ○ | ○ | ○ | ○ | ○ | ○ | ○ | ○ | ○ |
| Solder ball test | ⊙ | Δ | ○ | ○ | Δ | Δ | Δ | Δ | ⊙ | ○ | ○ | × | Δ | Δ |
| Void test | ⊙ | Δ | ○ | ○ | Δ | Δ | ○ | Δ | ⊙ | Δ | ○ | × | × | Δ |
| Solder crack test | ⊙⊙ | ⊙ | ⊙ | ⊙ | ⊙ | ⊙ | ⊙ | ⊙ | ⊙⊙ | ⊙ | ⊙ | ○ | ○ | ⊙ |

**[Table 7]**

| | Example 25 | Example 26 | Example 27 | Example 28 | Example 29 | Example 30 | Example 31 | Example 32 | Comparative Example 19 | Comparative Example 20 | Comparative Example 21 | Comparative Example 22 | Comparative Example 23 | Comparative Example 24 |
|---|---|---|---|---|---|---|---|---|---|---|---|---|---|---|
| Printability test (1) | ⊙ | ⊙ | ○ | ○ | ⊙ | Δ | Δ | ○ | × | × | × | Δ | × | Δ |
| Printability test (2) | ⊙ | ⊙ | ⊙ | ⊙ | ⊙ | Δ | ○ | Δ | Δ | Δ | Δ | Δ | ○ | Δ |
| Flux residue adhesiveness test | ⊙ | Δ | ○ | ○ | ⊙ | ⊙ | ○ | ○ | ⊙ | × | Δ | ⊙ | Δ | Δ |
| Copper plate corrosion test | ○ | ○ | ○ | ○ | ○ | ○ | ○ | ○ | ○ | ○ | ○ | ○ | ○ | ○ |
| Insulation resistance test | ○ | ○ | ○ | ○ | ○ | ○ | ○ | ○ | ○ | ○ | ○ | ○ | ○ | ○ |
| Solder ball test | ○ | Δ | Δ | Δ | Δ | Δ | Δ | Δ | O | Δ | Δ | × | Δ | Δ |
| Void test | ○ | Δ | Δ | Δ | Δ | Δ | Δ | Δ | ○ | Δ | Δ | × | × | Δ |
| Solder crack test | ⊙ | ○ | ○ | ○ | ○ | ○ | ○ | ○ | ⊙ | ○ | ○ | ○ | ○ | ○ |

**[Table 8]**

| | Example 33 | Example 34 | Example 35 | Example 36 | Example 37 | Example 38 | Example 39 | Example 40 | Comparative Example 25 | Comparative Example 26 | Comparative Example 27 | Comparative Example 28 | Comparative Example 29 | Comparative Example 30 |
|---|---|---|---|---|---|---|---|---|---|---|---|---|---|---|
| Printability test (1) | ⊙ | ⊙ | ○ | ○ | ⊙ | Δ | Δ | ○ | × | × | × | Δ | × | Δ |
| Printability test (2) | ⊙ | ⊙ | ⊙ | ⊙ | ⊙ | Δ | ○ | Δ | Δ | Δ | Δ | Δ | ○ | Δ |
| Flux residue adhesiveness test | ⊙ | Δ | ○ | ○ | ⊙ | ⊙ | ○ | ○ | ⊙ | × | Δ | ⊙ | Δ | Δ |
| Copper plate corrosion test | ○ | ○ | ○ | ○ | ○ | ○ | ○ | ○ | ○ | ○ | ○ | ○ | ○ | ○ |
| Insulation resistance test | ○ | ○ | ○ | ○ | ○ | ○ | ○ | ○ | ○ | ○ | ○ | ○ | ○ | ○ |
| Solder ball test | ○ | Δ | Δ | Δ | Δ | Δ | Δ | Δ | ○ | Δ | Δ | × | Δ | Δ |
| Void test | ○ | Δ | Δ | Δ | Δ | Δ | Δ | Δ | ○ | Δ | Δ | × | × | Δ |
| Solder crack test | ⊙ | ○ | ○ | ○ | ○ | ○ | ○ | ○ | ⊙ | ○ | ○ | ○ | ○ | ○ |

As indicated above, in Examples 1 to 40, good printability was ensured when using any of the alloys A to E, without impairing solderability (prevention of occurrence of voids and solder balls), and even though the pattern formation was printed using a 160-µm metal mask corresponding the fine pitch pattern. It was also indicated that all the flux residues formed using them achieved their reliability (adhesiveness and insulation resistance of the residues).

It was also indicated that the solder paste compositions according to Examples 9 to 40 comprising the alloys B to E having the specific alloy elements and specific alloy contents achieved higher crack growth inhibitory effect than the solder paste compositions according to Examples 1 to 8 comprising the alloy A. Accordingly, the solder paste compositions according to Examples 9 to 40 are suitable for electronic circuit boards which are exposed to severe temperature differences and required to have high reliability, particularly in-car electronic circuit boards.

## Claims

1. A solder paste composition comprising a solder alloy powder and a flux composition,
wherein the flux composition comprises (A) a base resin, (B) an activator, and (C) a paraffin wax,
wherein the solder alloy powder is a solder alloy powder comprising Sn, Ag and Cu,
wherein the paraffin wax (C) comprises 9% by mass or more and 20% by mass or less of isoparaffin and/or cycloparaffin, the remainder being normal type,
the amount of the base resin (A) is 10% by mass or more and 60% by mass or less with reference to the total amount of the flux composition,
the amount of the activator (B) is 0.1 % by mass or more and 30% by mass or less with reference to the total amount of the flux composition and
the amount of the paraffin wax (C) is from 0.5% by mass to 20% by mass with reference to the total amount of the flux composition.

2. The solder paste composition according to Claim 1, wherein the paraffin wax (C) consists of carbon and hydrogen.

3. The solder paste composition according to Claim 1 or Claim 2, wherein the carbon number distribution of the paraffin wax (C) is from 16 to 50, and the weight average molecular weight is 300 Mw or more and 600 Mw or less.

4. The solder paste composition according to any one of Claims 1 to 3, wherein the solder alloy powder comprises 2% by mass or more and 3.1% by mass or less of Ag, more than 0% by mass and 1% by mass or less of Cu, 1% by mass or more and 5% by mass or less of Sb, 0.5% by mass or more and 4.5% by mass or less of Bi, 0.01% by mass or more and 0.25% by mass or less of Ni and optionally 0.001% by mass or more and 0.25% by mass or less of Co, the balance being Sn.

5. An electronic circuit board comprising a solder joined body formed using the solder paste composition according to any one of Claims 1 to 4.

## Patentansprüche

1. Lötpastenzusammensetzung, umfassend ein Lötlegierungspulver und eine Flusszusammensetzung,
wobei die Flusszusammensetzung (A) ein Basisharz, (B) einen Aktivator und (C) ein Paraffinwachs umfasst,
wobei das Lötlegierungspulver ein Lötlegierungspulver ist, das Sn, Ag und Cu umfasst,
wobei das Paraffinwachs (C) 9 Masse-% oder mehr und 20 Masse-% oder weniger Isoparaffin und/oder Cycloparaffin umfasst, wobei das Übrige vom Normaltyp ist,
die Menge des Basisharzes (A) 10 Masse-% oder mehr und 60 Masse-% oder weniger in Bezug auf die Gesamtmenge der Flusszusammensetzung beträgt,
die Menge des Aktivators (B) 0,1 Masse-% oder mehr und 30 Masse-% oder weniger in Bezug auf die Gesamtmenge der Flusszusammensetzung beträgt und
die Menge des Paraffinwachses (C) 0,5 Masse-% bis 20 Masse-% in Bezug auf die Gesamtmenge der Flusszusammensetzung beträgt.

2. Lötpastenzusammensetzung nach Anspruch 1, wobei das Paraffinwachs (C) aus Kohlenstoff und Wasserstoff besteht.

3. Lötpastenzusammensetzung nach Anspruch 1 oder Anspruch 2, wobei die Kohlenstoffzahlverteilung des Paraffinwachses (C) 16 bis 50 beträgt, und das gewichtsmittlere Molekulargewicht 300 Mw oder mehr und 600 Mw oder weniger beträgt.

4. Lötpastenzusammensetzung nach einem der Ansprüche 1 bis 3, wobei das Lötlegierungspulver 2 Masse-% oder mehr und 3,1 Masse-% oder weniger Ag, mehr als 0 Masse-% und 1 Masse-% oder weniger Cu, 1 Masse-% oder mehr und 5 Masse-% oder weniger Sb, 0,5 Masse-% oder mehr und 4,5 Masse-% oder weniger Bi, 0,01 Masse-% oder mehr und 0,25 Masse-% oder weniger Ni und optional 0,001 Masse-% oder mehr und 0,25 Masse-% oder weniger Co umfasst, wobei der Rest Sn ist.

5. Elektronische Leiterplatte, umfassend einen lötverbundenen Körper, der unter Verwendung der Lötpastenzusammensetzung nach einem der Ansprüche 1 bis 4 gebildet ist.

## Revendications

1. Composition de pâte de brasage comprenant une poudre d'alliage de brasage et une composition de flux,
dans laquelle la composition de flux comprend (A) une résine de base, (B) un activateur, et (C) une cire de paraffine,
dans laquelle la poudre d'alliage de brasage est une poudre d'alliage de brasage comprenant Sn, Ag et Cu,
dans laquelle la cire de paraffine (C) comprend 9 % en masse ou plus et 20 % en masse ou moins d'isoparaffine et/ou cycloparaffine, le reste étant de type normal,
la quantité de la résine de base (A) est de 10 % en masse ou plus et de 60 % en masse ou moins par rapport à la quantité totale de la composition de flux,
la quantité de l'activateur (B) est de 0,1 % en masse ou plus et de 30 % en masse ou moins par rapport à la quantité totale de la composition de flux et
la quantité de la cire de paraffine (C) est de 0,5 % en masse à 20 % en masse par rapport à la quantité totale de la composition de flux.

2. Composition de pâte de brasage selon la revendication 1, dans laquelle la cire de paraffine (C) est constituée de carbone et d'hydrogène.

3. Composition de pâte de brasage selon la revendication 1 ou revendication 2, dans laquelle la distribution de nombre de carbone de la cire de paraffine (C) est de 16 à 50, et la masse moléculaire moyenne en masse est de 300 Mw ou plus et de 600 Mw ou moins.

4. Composition de pâte de brasage selon l'une quelconque des revendications 1 à 3, dans laquelle la poudre d'alliage de brasage comprend 2 % en masse ou plus et 3,1 % en masse ou moins de Ag, plus de 0 % en masse et 1 % en masse ou moins de Cu, 1 % en masse ou plus et 5 % en masse ou moins de Sb, 0,5 % en masse ou plus et 4,5 % en masse ou moins de Bi, 0,01 % en masse ou plus et 0,25 % en masse ou moins de Ni et éventuellement 0,001 % en masse ou plus et 0,25 % en masse ou moins de Co, le reste étant Sn.

5. Carte à circuit électronique comprenant un corps joint par brasage formé en utilisant la composition de pâte de brasage selon l'une quelconque des revendications 1 à 4.
